# EUROPÄISCHE PATENTSCHRIFT

(11) **EP 1 741 142 B1**
(45) Veröffentlichungstag und Bekanntmachung des Hinweises auf die Patenterteilung: **29.08.2012**
(21) Anmeldenummer: 05731015.3
(22) Anmeldetag: 06.04.2005
(51) Int. Cl.: H01L 29/808

(54) **HOCHVOLT-SPERRSCHICHT-FELDEFFEKTTRANSISTOR UND HERSTELLUNGSVERFAHREN**
HIGH VOLTAGE JUNCTION FIELD EFFECT TRANSISTOR AND MANUFACTURING METHOD
TRANSISTOR HAUTE TENSION A EFFET DE CHAMP A JONCTION ET METHODE DE FABRICATION

(30) Priorität: 08.04.2004 DE 102004018153
(43) Veröffentlichungstag der Anmeldung: 10.01.2007
(73) Patentinhaber: austriamicrosystems AG, 8141 Unterpremstätten (AT)
(72) Erfinder: KNAIPP, Martin, A-8141 Unterpremstätten (AT)
(74) Vertreter: Epping - Hermann - Fischer
(86) Internationale Anmeldenummer: PCT/EP2005/003623
(87) Internationale Veröffentlichungsnummer: WO 2005/098964

(56) Entgegenhaltungen:
- EP-A- 0 268 426
- EP-A- 0 981 166
- US-A- 3 841 917
- US-A- 4 185 291
- US-A- 6 096 587
- US-A- 6 153 453
- PATENT ABSTRACTS OF JAPAN Bd. 003, Nr. 015 (E-089), 9. Februar 1979 (1979-02-09) & JP 53 143183 A (HITACHI LTD), 13. Dezember 1978 (1978-12-13)
- NOUAILHAT A ET AL: "PERFORMANCE EVALUATION OF CMOS COMPATIBLE BIPOLAR TRANSISTORS AND VERTICAL JUNCTION FETS FOR ADVANCED VLSI TECHNOLOGY" ELECTRONICS LETTERS, IEE STEVENAGE, GB, Bd. 28, Nr. 23, 5. November 1992 (1992-11-05), Seiten 2195-2196, XP000315967 ISSN: 0013-5194
- PATENT ABSTRACTS OF JAPAN Bd. 004, Nr. 008 (E-166), 22. Januar 1980 (1980-01-22) & JP 54 149478 A (MATSUSHITA ELECTRIC IND CO LTD), 22. November 1979 (1979-11-22)

## Beschreibung

Die Erfindung betrifft einen Hochvolt-Feldeffekttransistor mit einer ersten Wanne eines ersten Leitfähigkeitstyps in einem Substrat eines zweiten Leitfähigkeitstyps, mit einer Source und einer Drain von jeweils dem ersten Leitfähigkeitstyp in der ersten Wanne, mit einem Gate des zweiten Leitfähigkeitstyps, das in einer zweiten Wanne des zweiten Leitfähigkeitstyps angeordnet ist.

Ein derartiger Feldeffekttransistor ist als Sperrschicht-Feldeffekttransistor (JFET) bekannt. Ein Vorteil dieses Typs von Feldeffekttransistor ist das geringe Rauschen. In Verbindung mit einer integrierten Schaltung werden diese Feldeffekttransistoren insbesondere in Leistungs-Anwendungen eingesetzt. Ein Ziel dieser Anwendungen ist es, einen Transistor bereit zu stellen, der eine hohe Durchbruchspannung mit einem niedrigen Widerstand im eingeschalteten Zustand verbindet und dabei eine geringe Fläche benötigt. Üblich sind spezielle Herstellungsprozesse für die JFETs mit epitaktischen Schichten.

Aus der US 2002/0132406 A1 ist ein vertikaler HochvoltTransistor mit mehrfachen Sperrschicht-Leitungskanälen bekannt, der in übereinander liegenden Ebenen einer n-Wanne vergrabene Zonen enthält.

Aus der US 6,153,453 ist ein Verfahren zur Herstellung eines Sperrschicht-Feldeffekttransistors in Verbindung mit weiteren MOS-Transistoren bekannt, die bei niedrigen Spannungen und Frequenzen eingesetzt werden. Für die Herstellung des Sperrschicht-Feldeffekttransistors wird der verwendete Niedervolt-Prozess der MOS-Transistoren mit geringen Änderungen verwendet.

Herkömmliche Strukturen von JFETs sind in US 4,185,291, JP 53 143183 A und JP 54 149478 A beschrieben.

Der Erfindung liegt die Aufgabe zu Grunde, einen verbesserten Hochvolt-Sperrschicht-Feldeffekttransistor und ein Herstellungsverfahren dafür anzugeben.

Diese Aufgabe wird mit dem Feldeffekttransistor mit den Merkmalen des Anspruchs 1 und mit dem Verfahren mit den Merkmalen des Anspruchs 7 gelöst. Ausgestaltungen der Erfindung sind in abhängigen Ansprüchen gekennzeichnet.

Die Erfindung hat den Vorteil, dass der Hochvolt-Sperrschicht-Feldeffektransistor zusammen mit weiteren Transistoren einer integrierten Schaltung hergestellt werden kann, ohne dass der Niedervolt-Prozess wesentlich geändert werden muss. Damit können die Eigenschaften der Niedervoltoder auch der anderen Hochvolttransistoren erhalten bleiben. Mit lediglich einer weiteren Maske, die auch für die Herstellung weiterer Hochvolt-Transistoren verwendet werden kann, gelingt die Herstellung des JFET. Die unterhalb des Gate erzeugte retrograde Wanne (zweite Wanne) bewirkt eine Vergleichmäßigung der elektrischen Feldstärken zwischen den hoch dotierten Gebieten, so dass der erfindungsgemäße Sperrschicht-Feldeffekttransistor bei hohen Spannungen ohne Gefahr eines Durchbruchs betrieben werden kann.

Unterhalb des Source- bzw. Drainanschlusses erstreckt sich je eine flache Wanne in die tiefe Wanne .

In einer Ausgestaltung der Erfindung ist vorgesehen, dass auf Feldoxidbereichen, die zwischen den hoch dotierten Anschlussbereichen angeordnet sind, Feldplatten erzeugt werden, mit denen eine Feldsteuerung möglich ist. Die Feldplatten können gleichzeitig mit den Elektroden der MOS-Transistoren des Niedervolt-Prozesses hergestellt werden.

In einer bevorzugten Ausführungsform ist vorgesehen, dass die Feldplatten etwa oberhalb des pn-Übergangs zwischen der ersten Wanne und der retrograden Wanne enden.

In einer anderen Ausführungsform sind die Feldplatten elektrisch mit der jeweils zugeordneten Source- oder und Drain-Anschlussbereichen verbunden.

Bei dem Verfahren zur Herstellung des Hochvolt-Feldeffekttransistors wird der Hochvolt-Feldeffekttransistor gleichzeitig mit weiteren MOS-Transistoren in der zweiten Wanne mittels einer Maskierung für die retrograde Wanne und nachfolgender Ionenimplantation hergestellt.

Bevorzugt wird mit einer Maske eine geringere Breite ("Schichtdicke" im Substrat) der ersten Wanne unterhalb der zweiten Wanne als außerhalb der zweiten Wanne eingestellt.

Die Erfindung wird nachfolgend an Hand von Ausführungsbeispielen in den Figuren der Zeichnung näher erläutert. Die Figuren dienen allein der Veranschaulichung der Erfindung und sind daher nur schematisch und nicht maßstabsgetreu ausgeführt. Unterschiedliche Bereiche gleichen Leitfähigkeitstyps sind schematisch durch punktierte oder strichlierte Linien abgegrenzt, während Bereiche unterschiedlichen Leitfähigkeitstyps schematisch mittels durchgezogener Linien abgegrenzt sind. Gleiche Elemente oder gleich wirkende Elemente sind mit gleichen Bezugszeichen versehen. Es zeigen:
- Figur 1: einen schematischen Querschnitt durch ein erstes Ausführungsbeispiel eines erfindungsgemäßen Sperrschicht-Feldeffekttransistors,
- Figur 2: einen schematischen Querschnitt durch ein zweites Ausführungsbeispiel des erfindungsgemäßen Sperrschicht-Feldeffekttransistors,
- Figur 3: einen schematischen Querschnitt durch ein drittes Ausführungsbeispiel des erfindungsgemäßen Sperrschicht-Feldeffekttransistors zur Erläuterung der Herstellung der Einsatzspannung,
- Figur 4: einen schematischen Querschnitt durch einen erfindungsgemäßen Sperrschicht-Feldeffekttransistor zusammen mit weiteren Transistoren und
- Figur 5: einen schematischen Querschnitt durch einen n-Kanal und einen p-Kanal-Niedervolt-Feldeffekttransistor im Zusammenhang mit Figur 4.

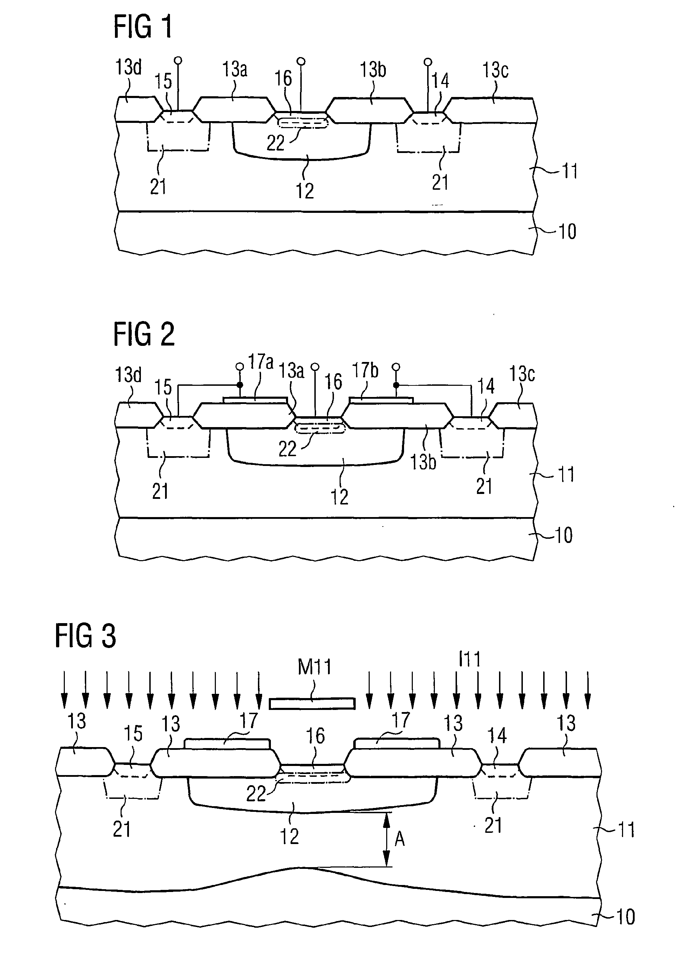

Gemäß Figur 1 ist in einem Substrat 10, insbesondere mit p-Leitfähigkeit, eine tiefe n-dotierte Wanne 11 angeordnet. An der Oberfläche der Anordnung, das heißt auf der Oberfläche der Wanne 11, sind Feldoxidbereiche 13a bis 13d hergestellt. Die Feldoxidbereiche 13 lassen Fenster frei, in denen die Anschlussbereiche der Feldeffekttransistoren als hoch dotierte Zonen angeordnet sind. So sind in der tiefen n-Wanne 11 der Sourceanschluss 14 und der Drainanschluss 15 hergestellt. Beide Bereiche 14 und 15 sind hoch dotiert und haben n-Leitfähigkeit. In einem Fenster zwischen Source und Drain ist, durch Feldoxidbereiche 13a und 13b getrennt, das Gate hergestellt. Der Gateanschluss 16 hat p-Leitfähigkeit und ist hoch dotiert. Bei dem Sperrschicht-Feldeffekttransistor handelt es sich demnach um einen n-Kanal Sperrschicht-Feldeffekttransistor (NJFET).

Unterhalb des Gateanschlusses 16 ist eine tiefe p-dotierte Wanne 12 als retrograde Wanne implantiert, die sich bis unter die Feldoxidbereiche 13a und 13b erstreckt. Die retrograde Wanne 12 hat ein Zentrum ihrer Dotierungskonzentration etwa mittig zwischen der Unterkante des Feldoxids und dem Grenzbereich zur tiefen n-Wanne 11. Unterhalb der tiefen p-Wanne 12 liegt in der tiefen n-Wanne 11 der Sperrschichtkanal, dessen Breite durch das an den Gateanschluss 16 angelegte negative Potenzial gesteuert wird. Damit kann mittels des Gatepotenzials in bekannter Weise der Stromfluss zwischen Source und Drain gesteuert werden. Der Sperrschichtkanal wird durch die n-Wanne 11 und die p-Wanne 12 und deren Dotierungen charakterisiert.

Die tiefe n-Wanne 11 und die hoch dotierten Bereiche 14, 15 und 16 können gleichzeitig mit entsprechenden Bereichen einer integrierten Schaltung erzeugt werden. Gleiches gilt für die Feldoxidbereiche 13. Für die retrograde Wanne 12 ist gegenüber einem reinen Niedervolt-Prozess eine zusätzliche Maskierung erforderlich, mit der gleichzeitig andere retrograde Wannen für Hochvolt-Feldeffekttransistoren auf der integrierten Schaltung hergestellt werden.

Zur weiteren Verbesserung der Spannungsfestigkeit bzw. der Hochvolteigenschaften ist unterhalb des Source- bzw. Drainanschlusses 14 bzw. 15 je eine flache n-Wanne 21 vorgesehen, die sich in die tiefe n-Wanne 11 erstreckt. Gleichfalls ist unterhalb des Gateanschlusses 16 eine flache p-dotierte Wanne 22 vorgesehen, die sich in die tiefe p-Wanne erstreckt. Die flache p-Wanne ist ebenfalls als retrograde Wanne implantiert. Die flachen Wannen 21 bzw. 22 sind niedriger dotiert als die darüber liegenden Anschlussbereiche 14, 15 bzw. 16, aber höher als die tiefen Wannen 11 bzw. 12. Dadurch kann die elektrische Feldstärke bei Anlegen einer Spannung an die Anschlussbereiche gesteuert bzw. linearisiert werden.

Um einen Durchbruch zwischen Gate und Source bzw. Drain an der Oberfläche der Anordnung bei besonders hohen Spannungen bzw. Potenzialen sicher zu verhindern, sieht das Ausführungsbeispiel gemäß Figur 2 auf den Feldoxidbereichen 13a bzw. 13b zusätzlich gegenüber Figur 1 Feldplatten 17a bzw. 17b vor. Die Feldplatte 17a ist dabei mit der Drain 15 elektrisch verbunden, während die Feldplatte 17b mit der Source 14 elektrisch verbunden ist. Die Feldplatten 17 erstrecken sich in etwa von dem Gateanschluss 16 bis oberhalb des Randes der retrograden Wanne 12. Die Feldplatten 17 haben eine hohe Leitfähigkeit und werden z.B. als Polysiliziumbereiche gleichzeitig mit Gate-Elektroden anderer Transistoren hergestellt.

Bei der Herstellung der Wannen, die sich hier nur beispielhaft auf einen 0,35 *µ*m-Niedervolt-Prozess beziehen, wird zunächst in dem Substrat 10 die n-Wanne 11 hergestellt. Mittels einer im Bereich des vorgesehenen JFET großflächigen Implantation werden Phosphor-Ionen mit einer Energie von vorzugsweise ca. 300 keV und einer Dosis von ca. 8,3 x 10¹² cm⁻³ implantiert. Phosphorionen sind beweglicher als grundsätzlich ebenfalls verwendbare Arsen-Ionen und bewirken eine gleichmäßigere Dotierungsverteilung in der n-Wanne.

Danach wird die p-Wanne hergestellt. Mittels einer an sich bekannten Maskierung, die im Bereich der zu erzeugenden Wanne ein Fenster hat, werden p-Ionen, bevorzugt Bor-Ionen, implantiert. Hierbei ist eine Doppelimplantation mit zunächst ca. 300 keV und einer Dosis von ca. 5 x 10¹² cm⁻³ vorgesehen und danach eine Implantation mit der Energie ca. 150 keV und der gleichen Dosis von ca. 5 x 10¹² cm⁻³.

Bei anschließenden thermischen Prozessschritten, beispielsweise im Zusammenhang mit der Herstellung der Feldoxidbereiche, diffundieren die Dotierstoffe der doetierten Bereiche aus. Die tiefe n-Wanne 11 ist allerdings schon vor der Implantation der tiefen p-Wanne 12 durch eine zu Prozessbeginn erfolgte n-Diffusion, z.B. bei 1150 °C über 700 Minuten, fast vollständig ausdiffundiert. Die tiefe p-Wanne 12 ist als retrograde Wanne ausgeführt, bei der auch nach der Durchführung der thermischen Schritte in der Wannentiefe eine höhere Dotierstoffkonzentration vorhanden ist als im oberen Bereich der Wanne.

Die Feldplatten 17 erlauben eine verbesserte Steuerung des elektrischen Feldes, so dass die Konzentration der n-Wanne 11 erhöht werden kann. Gleichzeitig erlaubt die verbesserte Feldsteuerung einen höheren Transistorstrom im eingeschalteten Zustand. Darüber hinaus kann die laterale Ausdehnung des Sperrschicht-Feldeffekttransistors kleiner dimensioniert werden, ohne dass es zu einem elektrischen Durchbruch kommt.

Gemäß Figur 3 ist dargestellt, wie die Einsatzspannung des Transistors nach Figur 2 eingestellt werden kann. Dazu wird bei der Implantation I11 der tiefen n-Wanne 11 im Bereich des späteren Gateanschlusses 16 ein definiertes Implantationsfenster mit der Abschattungsmaske M11 bei der an sich großflächigen Implantation vorgesehen. Die Maske M11 bewirkt, dass unter ihr weniger Phosphor-Ionen weniger tief in das Substrat 10 eindringen als außerhalb der Abschattungsmaske M11. Dadurch ersteckt sich nach den folgenden Temperaturschritten die tiefe n-Wanne in diesem Bereich nicht so tief in das Substrat 10 wie außerhalb und es ergibt sich die gezeigte verminderte Wannentiefe der tiefen n-Wanne 11. Zum Boden der retrograden tiefen p-Wanne kann dann mit deren Erzeugung der Abstand A eingestellt werden. Die tiefe n-Wanne 11 wird symmetrisch um den Gatebereich durch streifenförmige Implantationsöffnungen in der Abschattungsmaske implantiert. Je kleiner der Abstand A, umso kleiner ist die Einsatzspannung des Transistors. Bei einem großen Abstand A erhält man wegen der hohen Einsatzspannung sehr günstige Einschaltwiderstände. In diesem Fall werden aber die Feldplatten 17 zur Steuerung des elektrischen Feldes benötigt, damit man die hohe Gatespannung anlegen kann.

Eine Einsatzmöglichkeit des erfindungsgemäßen Sperrschicht-Feldeffekttransistors besteht darin, dass dieser beim Anlegen einer Spannung an die integrierte Schaltung einen Stromfluss ermöglicht und damit die Schaltung bzw. zunächst einen Spannungsregler aktivieren kann. Sobald der Spannungsregler seinen normalen Betriebszustand erreicht hat, kann dieser den Sperrschicht-Feldeffekttransistor ausschalten.

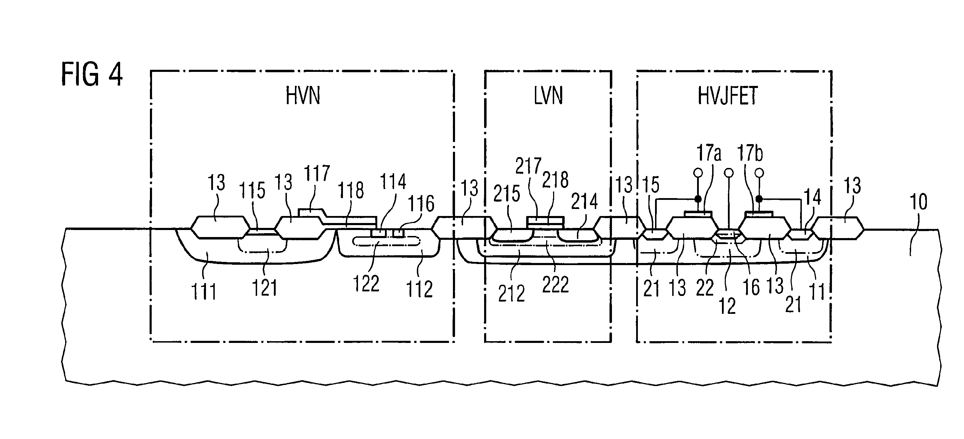

Gemäß Figur 4 ist ein Sperrschicht-Feldeffekttransistor HVJFET der beschriebenen Art zusammen mit einem NiedervoltTransistor LVN und einem weiteren n-Kanal Hochvolttransistor HVN, die jeweils ein isoliertes Gate haben, dargestellt. Der Übersichtlichkeit halber sind alle Anschlussbereiche für Gate, Source und Drain mit durchgezogenen Linien dargestellt.

Figur 4 entsprechend sind der n-Kanal Niedervolttransistor als LVN mit Drain 215, Source 214 und Gate 217, das durch ein Gateoxid 218 isoliert ist, in einer retrograden tiefen p-Wanne 212 angeordnet, die zusammen mit der tiefen p-Wanne 12 und der tiefen p-Wanne 112 hergestellt wird. In der tiefen p-Wanne 212 liegt eine flache p-Wanne 222 unterhalb der Anschlussbereiche. Die Kanalzone liegt zwischen Drain und Source. Es ist in diesem Fall vorgesehen, dass der n-Kanal Niedervolttransistor LVN und der Sperrschicht-Feldeffekttransistor HVJFET in derselben tiefen n-Wanne 11 angeordnet bzw. hergestellt sind.

Der Hochvolttransistor HVN hat in einem Fenster zwischen Feldoxidbereichen 13 die n-dotierte Drain 115, unter der eine flache n-Wanne 121 liegt, die wiederum in der tiefen n-Wanne 111 liegt. Dieser Wannenaufbau verringert die Feldstärkebelastung. Die n-dotierte Source 114 erstreckt sich bis zu einer flachen p-Wanne 122, die in einer retrograden tiefen p-Wanne 112 angeordnet ist. Ein ebenfalls n-dotierter Bereich 116 dient als Masseanschluss (body). Oberhalb der Kanalzone der tiefen p-Wanne 112 liegt die mittels eines Gateoxids 118 isolierte Gateelektrode, die sich bis auf den Feldoxidbereich 13 hin erstreckt und dort eine Feldplatte 117 zur Feldsteuerung bildet.

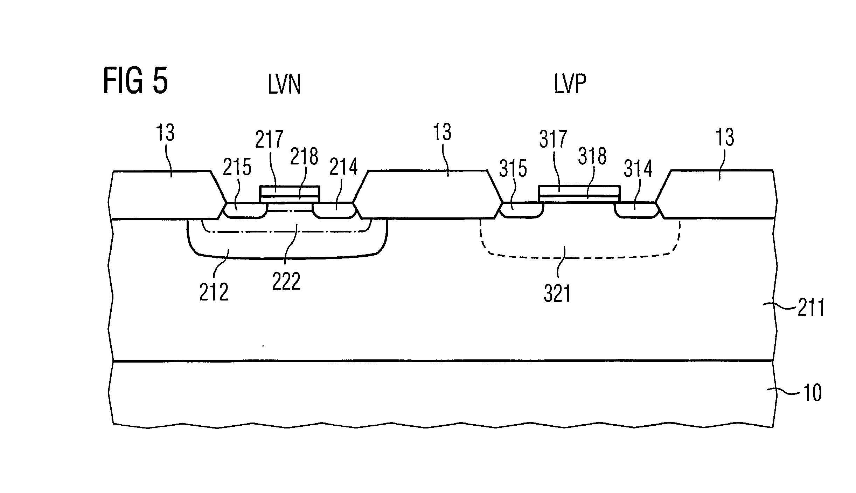

Gemäß Figur 5 ist in vergrößerter Weise der n-Kanal Niedervolttransistor LVN gemäß Figur 4 zusammen mit einem p-Kanal Niedervolttransistor LVP in einer tiefen n-Wanne 211 angeordnet. Der p-Kanal Niedervolttransistor LVP hat die Anschlussbereiche 314 und 315 für Source und Drain sowie das Gate 317 über dem Gateoxid 318. Source und Drain sowie die Kanalzone liegen in einer flachen n-Wanne 321.

Wie zu erkennen ist, können die tiefen n-Wannen 11, 111 und 211 sowie die tiefen p-Wannen 12, 112 und 212 im selben Prozessschritt des Niedervoltprozesses hergestellt werden. Ebenso können die flachen n-Wannen 21, 121 und 321 sowie die flachen p-Wannen 22, 122 und 222 im selben Prozessschritt hergestellt werden. Diese sogenannte Wiederverwendung (reuse) der Wannen bzw. deren Masken ermöglicht einen äußerst kostengünstigen Herstellprozess. Dabei sind folgende Zuordnungen getroffen.

Im Hochvolttransistor bildet die tiefe n-Wanne 111 die Driftzone für den NMOS-Transistor.
Die niedrig dotierten tiefen n-Wannen 11, 111 und 211 wirken allgemein als Isolationselement gegenüber dem p-Substrat 10. Die relativ hoch dotierte flache n-Wanne 121 dient zum Feldstärkeabbau (drain-engineering) des Hochvolt-Transistors, ebenso wie die flachen n-Wannen 21 und 321.

Die mit der retrograden Wanne 12 hergestellte tiefe p-Wanne 112 bzw. 212 bildet jeweils den Kanalbereich des Hochvolt-Transistors HVN und des Niedervolttransiators LVN. Die flache p-Wanne 122 bzw. 22 dient als Kanalbereich des Hochvolt-NMOS-Transistors HVN bzw. ist im Gatebereich des Hochvolt-Sperrschicht-Feldeffekttransitors vorgesehen. Weiterhin ist sie als Element 222 für den n-Kanal Niedervolttransistor LVN vorgesehen.

Die beschriebene funktionale Mehrfachnutzung der dargestellten Wannen für verschiedene Transistoren bildet einen erheblichen Effizienzgewinn bei der Herstellung derartiger Hochvoltbauelemente mittels eines Niedervoltprozesses. Mit nur 4 Wannen lassen sich sowohl Niedervolt- als auch Hochvolttransistoren herstellen. Auf diese Weise sind gegenüber anderen Herstellverfahren derartiger gemischter Bauelemente eine bedeutende Zahl an Masken und an Lithographieschritten und somit an Prozesskosten einzusparen. Gleichzeitig können die Hochvolttransistoren und die Niedervolttransistoren unabhängig voneinander optimiert werden. Auch dadurch lässt sich insbesondere bei den lateralen Hochvolttransistoren Silizium- bzw. Substratfläche sparen, was sich ebenfalls kostengünstig auswirkt.

## Patentansprüche

1. Hochvolt-Sperrschicht-Feldeffekttransistor mit einer ersten Wanne (11) eines ersten Leitfähigkeitstyps in einem Substrat (10) eines zweiten Leitfähigkeitstyps, mit einer Source (14) und einer Drain (15) in der ersten Wanne, die jeweils vom ersten Leitfähigkeitstyp sind, mit einem Gateanschluss (16) vom zweiten Leitfähigkeitstyp, der in einer zweiten Wanne (12) vom zweiten Leitfähigkeitstyp angeordnet ist, wobei die zweite Wanne vom retrograden Typ ist, und mit Feldoxidbereichen (13a, 13b), die zwischen Source, Gateanschluss und Drain angeordnet sind, wobei der Sperrschicht kanalbereich unterhalb der zweiten Wanne (12) und in der ersten Wanne (11) liegt,
**dadurch gekennzeichnet, dass**
sich unterhalb der Source bzw. der Drain je eine weitere Wanne (21) vom gleichen Leitfähigkeitstyp in die erste Wanne erstreckt und
sich unterhalb des Gateanschlusses eine weitere Wanne (22) vom gleichen Leitfähigkeitstyp in die zweite Wanne erstreckt.

2. Feldeffekttransistor nach Anspruch 1, **dadurch gekennzeichnet, dass** die zweite Wanne (12) bei der Implantation mit 5 x 10¹² cm⁻³ dotiert ist.

3. Feldeffekttransistor nach einem der Ansprüche 1 oder 2,
**dadurch gekennzeichnet, dass** sich von dem Gateanschluss (16) in Richtung auf Source (14) und Drain (15) Feldplatten (17a, 17b) auf den Feldoxidbereichen (13a, 13b) erstrecken.

4. Feldeffekttransistor nach Anspruch 3, **dadurch gekennzeichnet, dass** die Feldplatten (13a, 13b) etwa oberhalb des Halbleiterübergangs von der zweiten Wanne (12) zur ersten Wanne (11) enden.

5. Feldeffekttransistor nach Anspruch 3 oder 4, **dadurch gekennzeichnet, dass** die Source-seitige Feldplatte (17b) elektrisch mit der Source (14) und die Drain-seitige Feldplatte (17a) elektrisch mit der Drain (15) verbunden sind.

6. Feldeffekttransistor nach einem der Ansprüche 1 bis 5, **dadurch gekennzeichnet, dass** die Breite der ersten Wanne (11) unterhalb des Gateanschlusses (16) geringer als außerhalb des Gateanschlusses (16) ist.

7. Verfahren zur Herstellung eines Hochvolt-Feldeffekttransistors nach einem der Ansprüche 1 bis 6, **dadurch gekennzeichnet, dass** der Hochvolt-Feldeffekttransistor gleichzeitig mit weiteren MOS-Transistoren mittels einer Maskierung für die retrograde zweite Wanne (12) und nachfolgender Ionenimplantation hergestellt wird.

8. Verfahren nach Anspruch 7, **dadurch gekennzeichnet, dass** mit einer Maske (M11) eine geringere Weite, gemessen als Abstand vom Boden der zweiten Wanne (12) zum Substrat, der ersten Wanne (11) in einem Bereich unterhalb des Gateanschlusses (16) als außerhalb dieses Bereichs eingestellt wird.

9. Verfahren nach Anspruch 7 oder 8, **dadurch gekennzeichnet, dass** die Implantation der ersten Wanne durch streifenförmig angeordnete Öffnungen der Maske (M11) geschieht.

## Claims

1. A high-voltage junction field-effect transistor comprising a first well (11) of a first conductivity type in a substrate (10) of a second conductivity type, comprising a source (14) and a drain (15) in the first well which each are of the first conductivity type, comprising a gate terminal (16) of the second conductivity type arranged in a second well (12) of the second conductivity type, the second well being of the retrograde type, and comprising field oxide zones (13a, 13b) which are arranged between source, gate terminal and drain, the junction channel zone being situated underneath the second well (12) and in the first well (11),
**characterized in that**
a further well (21) of the same conductivity type extends respectively underneath the drain and the source into the first well, and
a further well (22) of the same conductivity type extends underneath the gate terminal into the second well.

2. The field-effect transistor according to claim 1,
**characterized in that** the second well (12) is doped with 5 x 10¹² cm⁻³ during implantation.

3. The field-effect transistor according to any of the claims 1 or 2, **characterized in that** field plates (17a, 17b) extend on the field oxide zones (13a, 13b) from the gate terminal (16) towards the source (14) and the drain (15).

4. The field-effect transistor according to claim 3,
**characterized in that** the field plates (17a, 17b) end approximately above the semiconductor junction from the second well (12) to the first well (11).

5. The field-effect transistor according to claim 3 or 4,
**characterized in that** the source-side field plate (17b) is electrically connected to the source (14) and the drain-side field plate (17a) is electrically connected to the drain (15).

6. The field-effect transistor according to any of the claims 1 to 5, **characterized in that** the width of the first well (11) underneath the gate terminal (16) is smaller than outside the gate terminal (16).

7. A method of manufacturing a high-voltage field-effect transistor according to any of the claims 1 to 6,
**characterized in that** the high-voltage field-effect transistor is manufactured simultaneously with further MOS transistors by means of a masking for the retrograde second well (12) and a subsequent ion implantation.

8. The method according to claim 7, **characterized in that** a width, measured as the distance from the bottom of the second well (12) to the substrate, is adjusted by means of a mask (M11) such that said width of the first well (11) in a zone underneath the gate terminal (16) is smaller than outside said zone.

9. The method according to claim 7 or 8, **characterized in that** the implantation of the first well is effected by openings of the mask (M11) which are arranged in stripe shape.

## Revendications

1. Transistor haute tension à effet de champ à couche d'appauvrissement comprenant une première cuvette (11) d'un premier type de conductivité dans un substrat (10) d'un deuxième type de conductivité, comprenant une source (14) et un drain (15) dans la première cuvette, lesquels sont chacun du premier type de conductivité, comprenant un raccord de grille (16) du deuxième type de conductivité, qui est disposé dans une deuxième cuvette (12) du deuxième type de conductivité, la deuxième cuvette étant du type rétrograde, et comprenant des zones d'oxyde de champ (13a, 13b) qui sont disposés entre la source, le raccord de grille et le drain, la zone de canal à couche d'appauvrissement étant située sous la deuxième cuvette (12) et dans la première cuvette (11),
**caractérisé en ce que**
sous la source et le drain, respectivement une cuvette supplémentaire (21) du même type de conductivité s'étend dans la première cuvette et,
sous le raccord de grille, une cuvette supplémentaire (22) du même type de conductivité s'étend dans la deuxième cuvette.

2. Transistor à effet de champ selon la revendication 1,
**caractérisé en ce que** la deuxième cuvette (12) est dopée de 5 x 10¹² cm⁻³ lors l'implantation.

3. Transistor à effet de champ selon l'une des revendications 1 ou 2, **caractérisé en ce que** des plaques de champ (17a, 17b) s'étendent sur les zones d'oxyde de champ (13a, 13b) depuis le raccord de grille (16) en direction de la source (14) et du drain (15).

4. Transistor à effet de champ selon la revendication 3,
**caractérisé en ce que** les plaques de champ (13a, 13b) se terminent approximativement au-dessus de la jonction de semiconducteur de la deuxième cuvette (12) à la première cuvette (11).

5. Transistor à effet de champ selon la revendication 3 ou 4, **caractérisé en ce que** la plaque de champ (17b) côté source est reliée électriquement à la source (14) et la plaque de champ (17a) côté drain est reliée électriquement au drain (15).

6. Transistor à effet de champ selon l'une des revendications 1 à 5, **caractérisé en ce que** la largeur de la première cuvette (11) sous le raccord de grille (16) est moindre par rapport à l'extérieur du raccord de grille (16).

7. Procédé de fabrication d'un transistor haute tension à effet de champ selon l'une des revendications 1 à 6,
**caractérisé en ce que** le transistor haute tension à effet de champ est fabriqué en même temps que d'autres transistors MOS moyennant un masquage pour la deuxième cuvette (12) rétrograde et implantation ionique consécutive.

8. Procédé selon la revendication 7, **caractérisé en ce que**, avec un masque (M11), une étendue moindre, mesurée comme distance du fond de la deuxième cuvette (12) au substrat, de la première cuvette (11) dans une zone située sous le raccord de grille (16) est réglée, par rapport à l'extérieur de cette zone.

9. Procédé selon la revendication 7 ou 8, **caractérisé en ce que** l'implantation de la première cuvette s'effectue par des ouvertures du masque (M11) disposées en forme de languettes.
